**Europäisches Patentamt**

**European Patent Office**

**Office européen des brevets**

(11) Veröffentlichungsnummer: **0 326 094**
**A1**

## (12) EUROPÄISCHE PATENTANMELDUNG

(21) Anmeldenummer: **89101249.4**

(22) Anmeldetag: **25.01.89**

(51) Int. Cl.⁴: **G01R 29/18**

(30) Priorität: **26.01.88 CH 254/88**

(43) Veröffentlichungstag der Anmeldung:
**02.08.89 Patentblatt 89/31**

(84) Benannte Vertragsstaaten:
**DE FR GB IT**

(71) Anmelder: **Reichle + De-Massari AG**
**Elektro-Ingenieure**
**Binzstrasse 31**
**CH-8620 Wetzikon(CH)**

(72) Erfinder: **Morach, Christoph**
**Luriweg 23**
**CH-8335 Hittnau(CH)**

(74) Vertreter: **Petschner, Goetz**
**Patentanwaltsbüro G. Petschner**
**Seidengasse 18**
**CH-8001 Zürich(CH)**

(54) **Prüfgerät für Drehstrom-Schaltungen.**

(57) Beim Drehrichtungsanzeiger umschliesst das Gehäuse (10) zwei, zwischen zwei Anschlüssen (L1 und L3) in Serie geschaltete und mit einer Mittelanzapfung (L2) versehene Parallel-Schaltungen (1 und 2) je eines Spannungsteilers (11 resp. 21) mit einem RC-Glied (12 resp. 22), wobei jeweils zwischen dem einen Spannungsteiler (11 resp. 21) der einen Parallel-Schaltung (1 resp. 2) und dem RC-Glied (22 resp. 12) der anderen Parallel-Schaltung (2 resp. 1) eine Signalleitung (3 resp. 4) mit einem optischen (5) resp. optischen (6) und akustischen Signalgeber (7) liegt.

Ein solches Gerät weist eine hohe Funktions- und Anzeigesicherheit auf und kann zudem zu weiteren Prüfungen, wie Phasenprüfung herangezogen werden.

## Prüfgerät für Drehstrom-Schaltungen

Die vorliegende Erfindung betrifft ein Prüfgerät für Drehstrom-Schaltungen, mit einem Gehäuse, das einen Prüfkreis mit Widerstands- und RC-Mitteln umfasst, der über Messkabel mit den Pol-Leitern der Drehstrom-Schaltung verbindbar ist, um bei einer Phasenverschiebung im Drehsinn des Drehfeldes der geprüften Drehstrom-Schaltung eine Spannung über einer Signalleitung mit einer Signallampe zu erzeugen.

Solche Prüfgeräte sind als sogenannte Drehrichtungsanzeiger zur Ueberprüfung des richtigen Anschlusses von beispielsweise Steckdosen an das Drehstrom-Netz u.dgl. im Gebrauch, wobei allerdings die Anzeige solcher Geräte mangelhaft und oft missverständlich ist, so dass Fehlschaltungen häufig sind.

Es ist deshalb Aufgabe der vorliegenden Erfindung, ein Prüfgerät der vorgenannten Art zu schaffen, das eine hohe Funktions und Anzeigesicherheit aufweist und zudem zu weiteren Prüfungen, wie Phasenprüfung herangezogen werden kann.

Dies wird erfindungsgemäss erreicht durch zwei, zwischen zwei Anschlüssen in Serie geschaltete und mit einer Mittelanzapfung versehene Parallel-Schaltungen je eines Spannungsteilers mit einem RC-Glied, wobei jeweils zwischen dem einen Spannungsteiler der einen Parallel-Schaltung und dem RC-Glied der anderen Parallel-Schaltung eine Signalleitung mit einem optischen und akustischen Signalgeber liegt.

Durch die wechselweise oder gleichzeitige Verwendung von optischen und akustischen Signalgebern wird bei einem solchen Prüfgerät nunmehr eine wesentlich grössere Sicherheit in der Erkennung richtiger oder falscher Anschlüsse am Drehstrom-Netz erreicht.

Hierbei kann eine hohe Funktionssicherheit des Drehrichtungsanzeigers weiter dann erreicht werden, wenn jedes RC-Glied auf einen vorgegebenen Phasenwinkel eingestellt ist, um bei einer Phasenverschiebung im Prüfkreis im Drehsinn des Drehfeldes der geprüften Drehstrom-Schaltung eine Spannung an der das Drehfeld als richtig anzeigenden Signalleitung und eine Null-Spannung an der anderen Signalleitung resp. um bei einer Phasenverschiebung im Prüfkreis im Gegendrehsinn des Drehfeldes eine Spannung an der einen Fehler anzeigenden Signalleitung und eine Nullspannung an der anderen Signalleitung zu erzeugen.

Ansich könnten sowohl in der einen oder anderen als auch in beiden Signalleitungen sowohl akustische als auch optische Signalgeber vorgesehen sein. Für einen eindeutigen und unmissverständlichen Hinweis auf einen Fehler ist es aber zweckmässig, wenn die einen Fehler anzeigende Signalleitung eine Signallampe sowie einen Summer umfasst.

Dies gestattet zudem eine akustische Anzeige bei einer Phasenprüfung.

Um die Handhabung des Drehrichtungsanzeigers zu verbessern, ist es zudem vorteilhaft, am Gehäuse einen Ansteckclip vorzusehen.

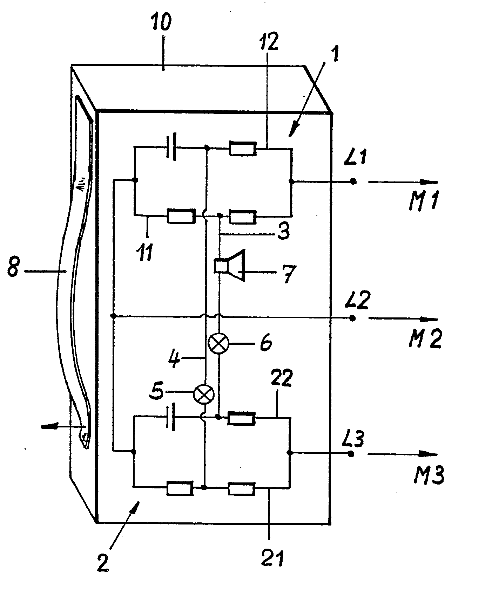

Eine beispielsweise Ausführungsform des Erfindungsgegenstandes ist nachfolgend anhand der Zeichnung, welche ein Prinzip-und Funktionsschema des erfindungsgemässen Prüfgerätes zeigt, näher erläutert.

Das erfindungsgemässe Prüfgerät umfasst ein Gehäuse 10, das vorzugsweise mit einem Ansteckclip 8 versehen ist, um dieses für eine bessere Handhabung an beliebigem Ort anstecken zu können.

Sichtbar am Gehäuse 10 sind ferner zwei Signallampen 5 und 6 unterschiedlicher Farbe, wie grün und rot, sowie drei An schlüsse L1, L2 und L3 für die Messkabel M1, M2 und M3, die fest oder steckbar mit dem Gehäuse verbunden sein können.

Erfindungsgemäss umschliesst das Gehäuse 10 einen Prüfkreis aus zwei, zwischen den Anschlüssen L1 und L3 in Serie geschaltete und mit einer Mittelanzapfung zum Anschluss L2 versehene Parallel-Schaltungen 1 und 2 je eines Spannungsteilers 11 resp. 21 mit einem RC-Glied 12 resp. 22. Hierbei ist jeweils zwischen dem einen Spannungsteiler 11 resp. 21 der einen Parallel-Schaltung 1 resp. 2 und dem RC-Glied 22 resp. 12 der anderen Parallel Schaltung 2 resp. 1 eine Signalleitung 3 resp. 4 geschaltet. Hierin führt die eine, den richtigen Drehsinn des Drehfeldes der geprüften Drehstrom-Schaltung anzeigende Signalleitung 4 über die grüne Signallampe 5. Die andere, Fehler in der Schaltung anzeigende Signalleitung 5 hingegen führt über die rote Signallampe 6 sowie über einen akustischen Signalgeber 7, beispielsweise in Form eines Piezo-Summers.

Die Prüfkreisanordnung 1,2 ist dabei so, dass jedes RC-Glied 12 resp. 22 auf einen vorgegebenen Phasenwinkel eingestellt ist, um bei einer Phasenverschiebung im Prüfkreis 1,2 im Drehsinn des Drehfeldes der geprüften Drehstrom-Schaltung eine Spannung an der das Drehfeld als richtig anzeigenden Signalleitung 4 und eine Null-Spannung an der anderen Signalleitung 3 resp. um bei einer Phasenverschiebung im Prüfkreis 1,2 im Gegendrehsinn des Drehfeldes eine Spannung an der einen Fehler anzeigenden Signalleitung 3 und eine Nullspannung an der anderen Signalleitung 4 zu erzeugen.

Mit dieser Prüfkreisanordnung 1,2 ist es also möglich, eine optimale Drehrichtungskontrolle an einer Drehstrom-Schaltung vorzunehmen, indem bei richtigem Drehsinn des Drehfeldes der geprüften Drehstrom-Schaltung die üblicherweise grüne Signallampe 5 aufleuchtet, wogegen bei falscher Drehrichtung durch Falschanschluss der Drehstrom-Schaltung nicht nur die rote Signallampe 6 aufleuchtet, sondern der Fehler zusätzlich durch ein lautes akustisches Signal angezeigt wird.

Darüber hinaus gestattet der Drehrichtungsanzeiger aber auch eine Kontrolle der Phasen, indem bei Phasenprüfung die beiden Signallampen schwach aufleuchten und ein relativ leises akustisches Signal ertönt, wenn Phase anliegt.

Auch wenn bei der Drehrichtungskontrolle ein Polleiter fehlt, leuchten beide Lampen auf und ertönt ein Signal.

Somit ergibt sich durch die erfindungsgemässen Massnahmen ein Drehrichtungsanzeiger von universellem Gebrauch und hoher Anzeige- und Funktionssicherheit.

## Ansprüche

1. Prüfgerät für Drehstrom-Schaltungen, mit einem Gehäuse, das einen Prüfkreis mit Widerstands- und RC-Mitteln umfasst, der über Messkabel mit den Pol-Leitern der Drehstrom-Schaltung verbindbar ist, um bei einer Phasenverschiebung im Drehsinn des Drehfeldes der geprüften Drehstrom-Schaltung eine Spannung über einer Signalleitung mit einer Signallampe zu erzeugen, gekennzeichnet durch zwei, zwischen zwei Anschlüssen (L1 und L3) in Serie geschaltete und mit einer Mittelanzapfung (L2) versehene Parallel-Schaltungen (1 und 2) je eines Spannungsteilers (11 resp. 21) mit einem RC-Glied (12 resp. 22), wobei jeweils zwischen dem einen Spannungsteiler (11 resp. 21) der einen Parallel-Schaltung (1 resp. 2) und dem RC-Glied (22 resp. 12) der anderen Parallel-Schaltung (2 resp. 1) eine Signalleitung (3 resp. 4) mit einem optischen (5) resp. optischen (6) und akustischen Signalgeber (7) liegt.

2: Prüfgerät nach Anspruch 1, dadurch gekennzeichnet, dass jedes RC-Glied (12 resp. 22) auf einen vorgegebenen Phasenwinkel eingestellt ist, um bei einer Phasenverschiebung im Prüfkreis (1,2) im Drehsinn des Drehfeldes der geprüften Drehstrom-Schaltung eine Spannung an der das Drehfeld als richtig anzeigenden Signalleitung (4) und eine Null-Spannung an der anderen Signalleitung (3) resp. um bei einer Phasenverschiebung im Prüfkreis (1,2) im Gegendrehsinn des Drehfeldes eine Spannung an der einen Fehler anzeigenden Signalleitung (3) und eine Nullspannung an der anderen Signalleitung (4) zu erzeugen.

3. Prüfgerät nach Anspruch 2, dadurch gekennzeichnet, dass die einen Fehler anzeigende Signalleitung (3) eine Signallampe (6) sowie einen Summer (7) umfasst.

4. Prüfgerät nach Anspruch 1, dadurch gekennzeichnet, dass das Gehäuse (10) mit einem Ansteckclip (8) versehen ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 180 773 (SHIAO) <br> * Zusammenfassung; Spalte 2, Anspruch 1 * | 1,2 | G 01 R 29/18 |
| Y | | 3 | |
| Y | DE-A-3 517 023 (BUCHHOLZ) <br> * Seite 3, Absatz 3; Figur * | 3 | |
| Y | DE-A-3 618 365 (ELECTRA) <br> * Spalte 2 * | 3 | |

**RECHERCHIERTE SACHGEBIETE (Int. Cl.4)**

G 01 R

Der vorliegende Recherchenbericht wurde für alle Patentansprüche erstellt

| Recherchenort | Abschlußdatum der Recherche | Prüfer |
|---|---|---|
| DEN HAAG | 02-05-1989 | HOORNAERT W. |

EPO FORM 1503 03.82 (P0403)